# EUROPEAN PATENT SPECIFICATION

(11) **EP 2 110 884 B1**
(45) Date of publication and mention of the grant of the patent: **29.05.2013**
(21) Application number: 08154524.6
(22) Date of filing: 15.04.2008
(51) Int. Cl.: H01Q 13/10, H01P 5/02, H01P 5/08, H01P 1/04, H01P 5/107, H01Q 13/18

(54) **Surface-mountable antenna with waveguide connector function, communication system, adaptor and arrangement comprising the antenna device**
Flächenmontierbare Antenne mit Wellenleiter-Anschlussfunktion, Kommunikationssystem, Adaptor und Anordnung mit der Antennenvorrichtung
Antenne montable en surface dotée d'une fonction de connecteur de guide d'onde, système de communication, adaptateur et agencement comprenant le dispositif d'antenne

(43) Date of publication of application: 21.10.2009
(60) Divisional application: 10164756.8
(73) Proprietor: Sub10 Systems Limited, Kingsteignton Newton Abbot TQ12 3RZ (GB)
(72) Inventor: Grzyb, Janusz, 8330 Pfäffikon ZH (CH); Goebel, Uhland, 8492 Wila (CH)
(74) Representative: Exell, Jonathan Mark

(56) References cited:
- EP-A- 0 905 814
- EP-A- 1 274 149
- DE-A1-102006 019 054
- JP-A- 11 312 908
- US-A- 4 453 142
- SANTIAGO SIERRA-GARCIA ET AL: "Study of a CPW Inductively Coupled Slot Antenna" IEEE TRANSACTIONS ON ANTENNAS AND PROPAGATION, IEEE SERVICE CENTER, PISCATAWAY, NJ, US, vol. 47, no. 1, 1 January 1999 (1999-01-01), XP011003447 ISSN: 0018-926X
- KATSUMI TAKATA ET AL: "Electrical properties and practical applications of Liquid Crystal Polymer flex" POLYMERS AND ADHESIVES IN MICROELECTRONICS AND PHOTONICS, 2007. POLYTR ONIC 2007. 6TH INTERNATIONAL CONFERENCE ON, IEEE, PI, 1 January 2007 (2007-01-01), pages 67-72, XP031139340 ISBN: 978-1-4244-1130-6

## Description

The present invention concerns antennas and communication systems based thereon and corresponding arrangements.

### Background art

Conventional microwave and millimeter wave radio applications are usually built of discrete passive and active components individually assembled on a common high-frequency substrate or board, resulting in a low integration level.

The performance of such a radio application, in particular at millimeter wave frequencies, is typically limited by the number of permissible consecutive interfaces or transitions between discrete components, which is a function of the quality of the above-mentioned common substrate and the capability of the interconnect technology to reproduce a predefined reflection coefficient.

In an effort to significantly reduce the overall cost of communication systems and applications, low cost key components like high gain antennas, filters, and front end modules are under development.

A key requirement for higher volume market penetration is a significant reduction of the overall costs. Typical cost drivers are the antennas, as such.

The following main features of a modern, antenna-based radio communication system may be highly desirable:
- modular and reconfigurable build-up allowing to use the unit in different application scenarios, e.g. indoor, point-to-point outdoor, etc.
- capable of delivering both fully testable transmitter and receiver sides of the completely assembled system, up to and including the antenna, avoiding the ambiguities of propagation dependent link tests by creating well-defined, reproducible, shielded signal ducts.
Document EP-A2-905814 describes an antenna as set out in the preamble of claim 1.

A novel approach applying a suitable integration methodology is believed to be a key factor for the successful low cost and high performance realization of the above-mentioned envisioned radio systems. It should enable millimeter wave units with minimum microwave technology used and substantially simplified assembly. Ideally, the need for an expensive high-frequency common substrate carrier could be entirely eliminated. It should also deliver both antenna and integrated waveguide transition designs that show little sensitivity to a variable package- and board-level EM environment and are easily transferable to different manufacturing and assembly setups.

### SUMMARY OF THE INVENTION

It is thus the main objective of the present invention to provide a simple antenna device that can be directly connected to a planar (e.g. millimeter wave) circuit.

It is another objective of the present invention to provide a reliable and reproducible interface to additional waveguide-based (e.g. millimeter wave) active and passive components.

It is another objective of the present invention to provide a reproducible, low loss, fully shielded test and measurement interface to a planar (e.g. millimeter wave) circuit.

The present invention is directed to constructing a low cost medium gain (5 - 10dBi) modular surface-mountable antenna for highly integrated radio applications.

The inventive surface-mountable antenna has two main functions. The first function is the function of a regular antenna for radiating and/or receiving electromagnetic energy into (out of) free space. The second function is an adaptor function where the antenna constitutes a first part of a planar-circuit-to-waveguide transition. The antenna is, hence, also called connector base or female adaptor part. As the second part of the planar-circuit-to-waveguide transition, a connector plug or male adaptor part is used. It can be repeatedly attached to the antenna, thereby creating a low loss, broadband and reproducible planar-circuit-to-waveguide transition.

The antenna presented herein is a surface mountable, quasi-planar, antenna with an integrated waveguide connector function.

According to the present invention, the main elements of the inventive antenna comprise a reflector frame and a radiating element with an at least slightly bendable cantilever interface to an active (planar) circuit. The millimeterwave waveguide antenna itself is formed by the radiating element and two cavities, namely a back reflector cavity and an open cavity. The radiating element is mounted inside the reflector frame, providing a common interface between these two cavities. The entire antenna is mounted on top of an electrically conducting plane located on a common substrate, yielding the back reflector cavity as an essentially electromagnetically shielded volume.

The inventive antenna device, which constitutes the first part of a planar-circuit-to-waveguide transition, has the following main characteristics:
- It has a quasi-planar shape where the "z-axis" dimension is much smaller than "x-axis" and "y-axis" dimensions.
- It provides for a bendable mechanical and electrical interface to a planar active circuit (transmitter or receiver) chip.
- It may use a flexible high-frequency substrate for the radiating element;
- It is "waveguide-ready", i.e. it is designed to support/receive the adaptor/connector functionality.
- It provides for a mechanical and electromagnetic interface to an adaptor.

The antenna device presented herein is designed to be used preferably for millimeter wave applications and communication systems. The present invention achieves a significant cost reduction by employing a modular cost effective design.

Operating at other frequency bands not being excluded, one frequency band of special interest is the worldwide license-exempt range from 57 to 66 GHz (the corresponding standardized waveguide band being V-band, 50 to 75GHz), another commercially interesting band is the combination of 71 - 76GHz and 81 - 86GHz ranges (the corresponding standardized waveguide band being E-band, 60 to 90GHz). In the first case, the antenna device should preferably cover the 57 to 66GHz range with good matching properties and radiation efficiency, whereas in the function of a complete planar-circuit-to-waveguide transition, full V-band coverage would be desirable. In the second case, the antenna device should preferably cover the 71 to 86GHz range, whereas in the function of a planar-circuit-to-waveguide transition, full E-band coverage would be desirable.

The antenna presented herein has the advantage of being compatible to low cost, high volume manufacturing and assembly technologies. Another advantage is the small form factor of the quasi-planar antenna and the fact that it has a chip-scale size.

Depending on the actual implementation, the antenna device is capable of supporting an input impedance bandwidth sufficiently large for Gbps wireless data communication (relative bandwidth greater than 20%).

Other advantages are obtained, namely a flat gain response with respect to frequency and a high radiation efficiency (typically above 80%). The antenna device may furthermore have a medium gain (5 - 10 dBi), being sufficient for near-range point-to-point communication applications.

The foregoing and other objects and advantages of the invention will appear from the following description. In the description, reference is made to the accompanying drawings which form a part thereof, and in which there are shown by way of illustration, preferred embodiments of the invention. Such embodiments do not necessarily represent the full scope of the invention, however, and reference is therefore made to the claims herein for interpreting the scope of the invention.

### FIGURES

- Fig. 1A:: is a schematic block diagram of an antenna device, according to the present invention;
- Fig. 1B:: is a schematic block diagram of a first communication system comprising an active device and an antenna device, according to the present invention;
- Fig. 1C:: is a schematic block diagram of a second communication system comprising an active device and an antenna device according to the present invention and an adaptor;
- Fig. 1D:: is a schematic block diagram of a third communication system comprising an active device, an antenna device and a waveguide element, according to the present invention and an adaptor;
- Fig. 1E:: is a schematic block diagram of a fourth communication system comprising an active device, an antenna device and an antenna, according to the present invention and an adaptor;
- Fig. 2A:: is a perspective top view of a first planar antenna device, according to the present invention;
- Fig. 2B:: is a perspective bottom view of a first planar antenna device, according to the present invention;
- Fig. 2C:: is a side view of a first planar antenna device as mounted on the common substrate, according to the present invention;
- Fig. 2D:: shows a perspective view of a radiating element to be mounted in a first planar antenna device, according to the present invention;
- Fig. 2E:: is a top view of a first planar antenna device showing certain details of the radiating element;
- Fig. 2F:: is a perspective semitransparent view of a reflector frame of a first planar antenna device according to the present invention;
- Fig. 3:: is a perspective view of a first communication system comprising a planar antenna device and some electronic components connected by a feedpoint section, and as mounted on a common substrate;
- Fig. 4:: is a perspective semitransparent view of a second communication system or arrangement comprising a planar antenna device, according to the present invention and an adaptor;
- Fig. 5A:: shows a top view of an adaptor mounted on top of a planar antenna device with the mating elements clearly visible, according to the present invention;
- Fig. 5B:: a semitransparent side view of the adaptor of Fig. 5A mounted on top of the planar antenna device showing the mating elements providing both a mechanical and an electrical contact, according to the present invention;
- Fig. 6A:: is a schematic block diagram of a first calibration standard with planar antenna devices as ports;
- Fig. 6B:: is a schematic block diagram of a second calibration standard with planar antenna devices as ports;
- Fig. 6C:: is a schematic block diagram of a third calibration standard with planar antenna devices as ports;
- Fig. 7A:: is a perspective top view of another planar antenna device, according to a second embodiment of the present invention;
- Fig. 7B:: is a perspective bottom view of the second embodiment of the present invention;
- Fig. 7C:: is a side view of the second embodiment as mounted on the common substrate, according to the present invention;
- Fig. 7D:: is a semitransparent top view of the second embodiment of the present invention;
- Fig. 7E:: shows a perspective view of a radiating element, according to the second embodiment of the present invention;
- Fig. 7F:: is a top view of the second embodiment of the present invention;
- Fig. 8:: is a perspective view of another arrangement comprising a planar antenna according to the present invention and an adaptor;
- Fig. 9A:: is a side view of an adaptor mounted on an antenna device according to the present invention;
- Fig. 9B:: is a cross-section of the adaptor and antenna device of Fig. 9A according to the present invention;
- Fig. 9C:: is a cross-section of the adaptor of Fig. 9AFig. 9D: shows a perspective view of a communication system, according to a third embodiment of the present invention;
- Fig. 10:: shows a perspective view of a communication system, according to a fourth embodiment of the present invention;

Detailed description:

### Terms

The following sections describe several terms used throughout the specification and the claims to facilitate discussion of the invention.

In the following text, cast parts are discussed. According to the present invention, the term "cast part" is to be understood as parts which were either produced using an (automatic) injection molding method or a powder injection molding (PIM) process with subsequent sintering. In the first case, thermoplastics may be used, yielding the final dimensions in a 1-step process.

According to the present invention, various plastic injection molding compounds may be used in order to produce the cast parts. Some examples of suited plastics are listed in the following: PA (polyamide); POM (polyoxymethylene); PET (polyethylene terephthalate); PS (polystyrene); LCP (liquid crystal polymer); PBT (polybutylene terephthalate); ABS (acrylate-butadiene-styrene); PPE (polyphenylene ether); PP (polypropylene); PMMA (polymethylmethacrylate); PC (polycarbonate); PAS (polyaryl sulfone); PES (polyether sulfone); PEI (polyether imide); PAI (polyamide imide); PPS (polyphenylene sulfide); PVDF (polyvinylidene fluoride); PEEK (poly ether ether ketone).

Polymer blends may also be used. These are combinations of two or more miscible polymers. Blending is processing, mixing, or reacting two or more polymers to obtain improved product properties.

Modified plastics having filler particles may also be used, which makes the construction of solidly adhering non-electrode or galvanically deposited metal coatings easier. The filler particles may be made of electrically conductive metals (e.g., palladium) or of electrically non-conductive metal pigments, as used in spray lacquers for electromagnetic shielding. These metal pigments are used as a catalyst for non-electrode deposition of a metallic primer coating, which may subsequently be galvanically reinforced. The spray lacquer achieves only a limited adhesive strength, which is strongly dependent on the plastic material. By embedding the particles in the plastic compound, a significant improvement of the adhesive strength is achieved in that the particles are exposed only on the surface through a short pickling process or by laser ablation, but otherwise they remain enclosed by the plastic compound.

Another important group of modified plastics employs a combination of glass fibers and mineral or ceramic particles for adjusting the coefficient of thermal expansion (CTE) to the one of the common substrate.

Instead of plastic, metals may also be used for producing the cast parts. Aluminum is especially suitable, which may be processed in the aluminum injection molding method. Titanium or Stainless Steel can be used by employing the metal injection molding (MIM) process, which is a variant of the above-mentioned powder injection molding (PIM) process. An advantage of this approach may be the simplification or even evasion of a subsequent metal plating step.

The cast parts are distinguished in that a minimum of post-processing outlay is necessary. For this reason, the cast parts are herein also referred to as precasts or finished parts. The dimensions of the cast parts are very precise.

Reflectors which preferably have a conductive surface may be used. This conductive reflector surface may be set to ground. The reflector surface may be implemented as flat or curved. Preferably a metal surface on a common substrate serves as reflector.

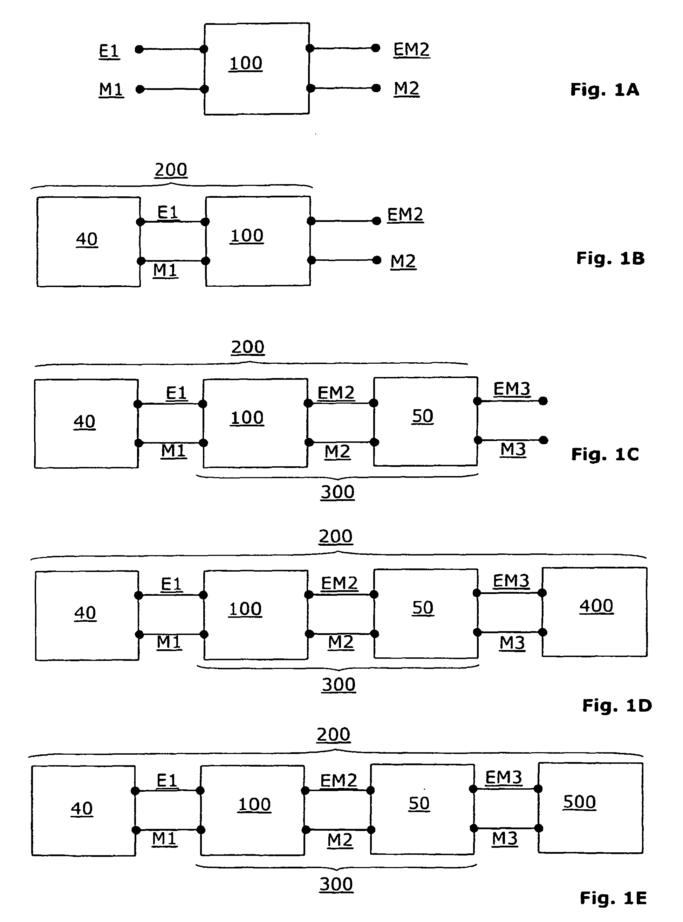

Before addressing specific embodiments of the invention, some basic aspects are addressed and explained by reference to the Figures 1A through 1E.

One key element of the present invention is the so-called surface-mountable antenna device 100, as schematically illustrated in Fig. 1A. This antenna device 100 comprises four interfaces E1, M1, EM2 and M2, represented by the four horizontal lines in Fig. 1A. The two interfaces E1 and M1 on the left hand side of Fig. 1A are devised to establish a connection to an active circuit 40 (cf. Fig. 1B). The first interface is an electric interface E1, and the second interface is a mechanical interface M1. The other two interfaces are an electromagnetic interface EM2 and a mechanical interface M2. As a means of distinction, we denote an interface that predominately exhibits both electric and magnetic transversal field components in its plane as electric interface (an example being a joint of TEM or quasi-TEM transmission lines), and an interface that exhibits significant electric or magnetic longitudinal field components as electromagnetic (an example being a rectangular waveguide joint).

A first communication system 200 comprising an active device 40 and an antenna device 100, according to the present invention, is illustrated in Fig. 1B.

A second communication system 200 comprising an active device 40, an antenna device 100 according to the present invention and an adaptor 50, is illustrated in Fig. 1C. The antenna device 100 and adaptor 50 together are referred to as arrangement 300. The adaptor 50 has four interfaces (two electromagnetic and two mechanical ones). EM2 and M2 establish a preferably detachable connection to the antenna device 100 while interfaces EM3 and M3 can be used to attach additional components.

A third communication system 200 comprising an active device 40, an antenna device 100 and a waveguide element 400, according to the present invention and an adaptor 50, is illustrated in Fig. 1D. The adaptor 50 has four interfaces (two electromagnetic and two mechanical ones). EM2 and M2 establish a preferably detachable connection to the antenna device 100 while interfaces EM3 and M3 are connected to the waveguide element 400. This waveguide element 400 has at least two interfaces (an electromagnetic and a mechanical one) which are connected to the interfaces EM3, M3. It may have additional interfaces, which are dealt with as internal features for the sake of clarity.

A fourth communication system 200 comprising an active device 40, an antenna device 100 and an antenna 500, according to the present invention and an adaptor 50, is illustrated in Fig. 1E. The adaptor 50 has four interfaces (two electromagnetic and two mechanical ones). Two are connected to the interfaces EM2, M2 of the antenna device 100. The remaining two interfaces EM3 and M3 are connected to the antenna 500. This antenna 500 has at least two interfaces (an electromagnetic and a mechanical one) which are connected to the interfaces EM3, M3. The electromagnetic interface constituted by the aperture radiating into free space is again omitted for the sake of clarity as it is normally not intended for attaching further components.

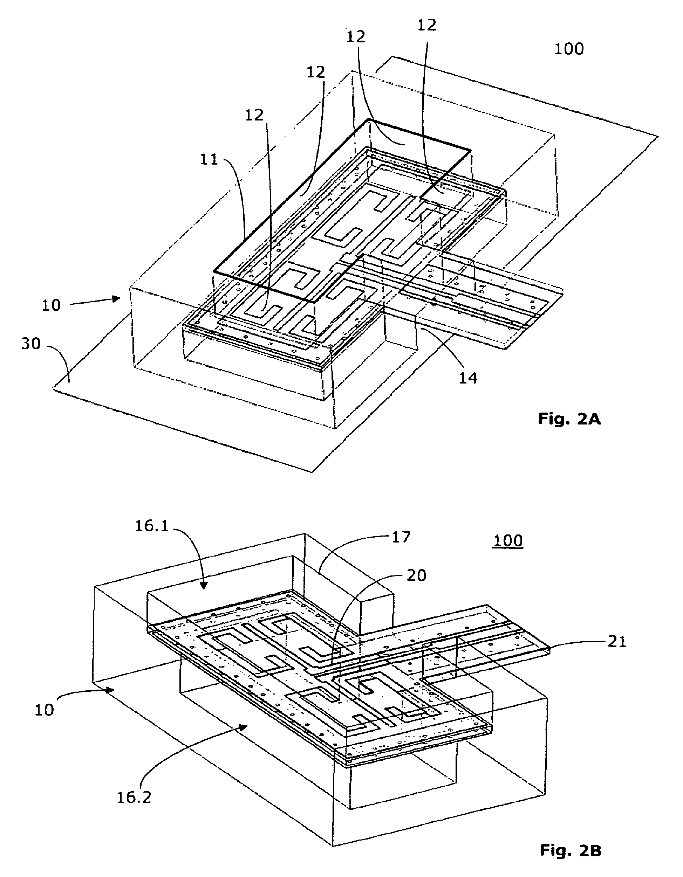

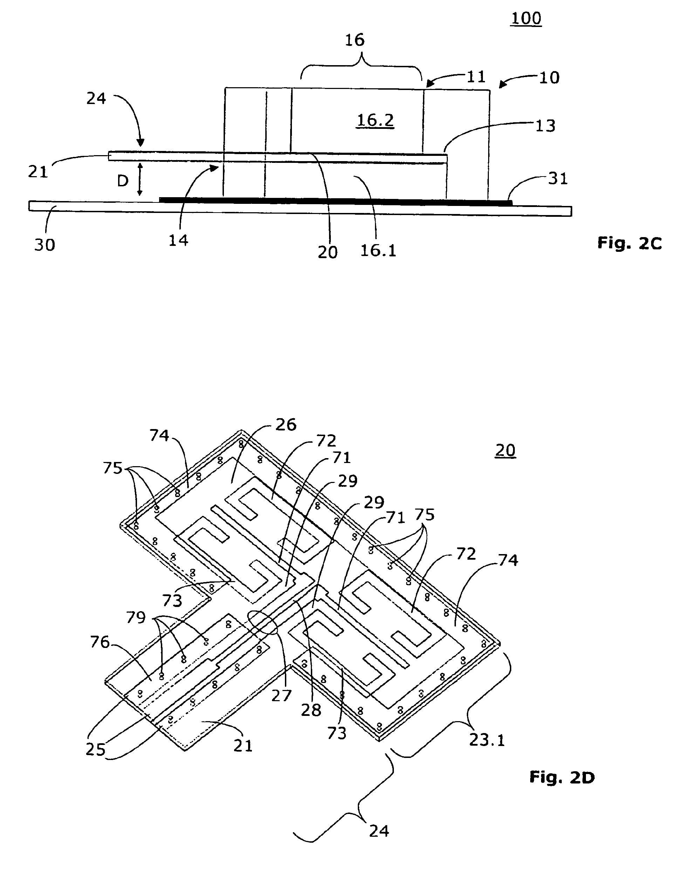

A first planar antenna device 100 is shown in Figures 2A - 2F. The antenna device 100, according to the present invention, comprises at least a reflector frame 10 and a radiating element 20 (cf. Fig. 2B). The reflector frame 10 has circumferential sidewalls 12 which provide for a lateral definition of an interior section or cavity 16 (cf. Fig. 2C). A lateral opening 14 is provided in one of the sidewalls 12. An upper horizontal opening 11 of the interior section 16 serves as electromagnetic aperture which establishes or which is part of the electromagnetic interface EM2 in Fig. 1A. This part of the interior section is referred to as open cavity 16.2 (cf. Fig. 2B). A lower horizontal opening 17 of the interior section 16 is designed to be mounted or placed on top of a metal plane 31 (cf. Fig. 2C). When mounted or placed on top of the metal plane 31, an electromagnetic back reflector structure or back reflector cavity 16.1 of the antenna device 10 is formed.

The reflector frame 10 further comprises a support structure 13 (cf. Fig. 2C). This support structure 13 is an integral part of the reflector frame 10. A step or ridge may serve as support structure 13.

The radiating element 20 has a planar, horizontally-oriented antenna substrate 21 with a rectangular mode conversion area 23.1 and a cantilever-shaped feedpoint section 24 protruding from the mode conversion area 23.1 (cf. Fig. 2D) in an essentially horizontal direction. The feedpoint section 24 serves as electric interface E1 (cf. Fig. 1A), connecting the antenna device 100 to an active device 40. In a preferred embodiment of the invention, feedpoint section 24 features a coplanar waveguide 27 which is entering the rectangular mode conversion area 23.1 approximately at the centre of one of its broader edges. The coplanar waveguide 27 is established by two parallel slots in a thin electrically conducting sheet 26 which is adherent to one of the larger surfaces of the substrate 21, resulting in a centre conductor 28 and two ground conductors 29. In the rectangular mode conversion area 23.1 the electrically conducting sheet 26 has at least one slot 71, running perpendicular to the coplanar waveguide 27. The centre conductor 28 is electrically connected to the far edge of the slot 71, the ground connectors 29 to the near edge. This slot 71 is preferably placed in the centre of area 23.1. The length of the slot 71 is chosen to be equal to approximately half of the wavelength at the centre of the intended frequency band.

In a further improved embodiment, one or two pairs of slots 72, 73 are situated adjacent to slot 71 and are folded in order to accommodate a length of approximately half of the wavelength at the centre of the intended frequency band. Preferably, at least one short end-section of either slot 72 or 73 is running parallel and in close proximity to slot 71, thereby providing for electromagnetic coupling between 71 and 72, 73, respectively.

According to the invention, the radiating element 20 is mounted by the support structure 13 inside the interior section 16 so that the interior section 16 is divided into the above-mentioned back reflector cavity 16.1 and the open cavity 16.2 (cf. Fig. 2C). The feedpoint section 24 extends from the interior section 16 through the lateral opening 14 in order to provide for a connection (electric interface E1) to an active circuit 40.

According to the invention, the reflector frame 10 comprises metal or is at least partially metallised.

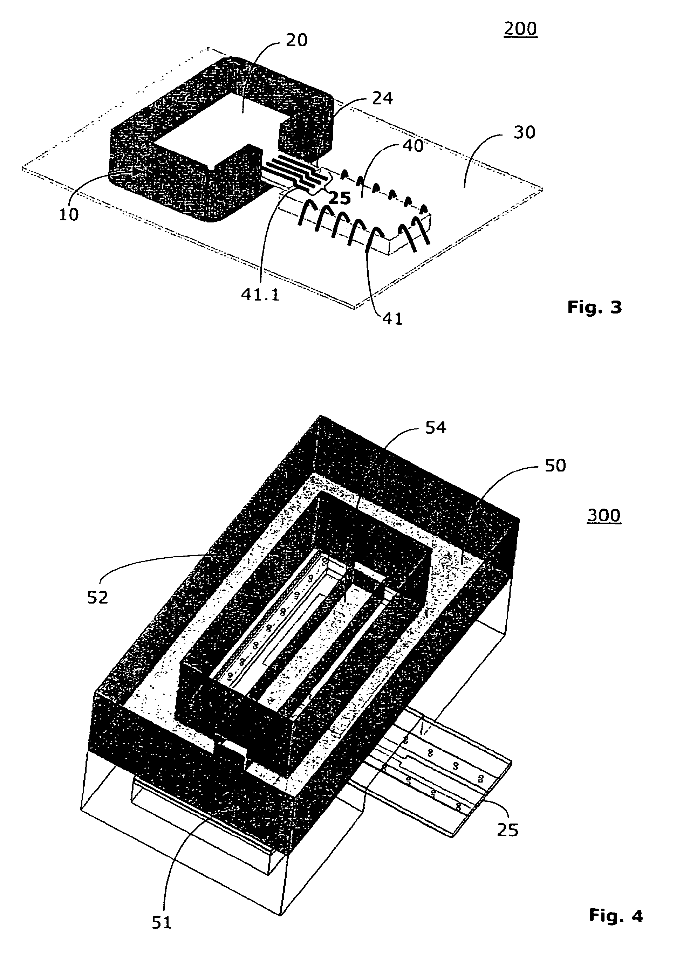

The planar antenna device 100 is by design so constructed as to be integrated onto a common substrate 30 such as a low frequency board, a printed circuit board or a similar support structure (cf. Fig. 2C or 3, for instance). A common requirement for all these in order to be suitable for accommodating the reflector frame 10 is to feature a horizontal metal plane 31 acting as a back reflector for the radiating element 20.

The reflector frame 10 of the antenna device 100 has a quasi-planar layout wherein the "z-axis" dimension is much smaller than the "x-axis" and "y-axis" dimensions. The z-axis is perpendicular to the x-y-plane, and the (antenna) substrate 21 lies in the x-y plane. Preferably, the height (in z-direction) of the frame 10 is between 1 and 5 times the height of the planar circuit 40. If a planar 500 µm thick SiGe chip 40 is employed, then the height of the back reflector cavity 16.1 may also be about 500 µm.

Small differences between the height of the circuit 40 and the height D of the feedpoint section 24 (cf. Fig. 2C) of the inventive antenna device 100 can be bridged by a (slightly or completely) bendable cantilever, as will be explained later.

In a preferred embodiment, the reflector frame 10 comprises a support structure 13 designed to accommodate the radiating element 20, said support structure 13 matching the shape of the antenna substrate 21 of the radiating element. That is, the reflector frame 10 serves as mechanical support structure for supporting the antenna substrate 21. The reflector frame 10 is a 3D constituent of the antenna device 100 and is part of the mechanical interface M1 for mounting the entire antenna device 100 on a (common) substrate 30. The reflector frame 10 also serves as mechanical interface M2 since it is designed to receive an adaptor 50.

The dimensions of the lower cavity 16.1 of the reflector frame 10 are chosen so that the radiating element 20 can be inserted into the interior section 16 through this lower cavity 16.1. For this reason, the horizontal dimensions of the lower cavity 16.1 are somewhat larger than the horizontal dimensions of the radiating element 20, that also exhibits somewhat larger horizontal dimensions than the upper portion of the frame 10 or open cavity 16.2.

To accommodate the radiating element 20, the shape and details of which will be discussed later, one of the sidewalls 12 of the reflector frame 10 has a lateral opening 14 where a feedpoint 24 of the radiating element 20 can extend out of the reflector frame's interior section 16. In a preferred embodiment, a bendable cantilever interface (electrical interface E1 in Fig. 1A) to a planar circuit 40 is provided.

In a preferred embodiment, at least the sidewalls 12 of the reflector frame 10 facing the interior section 16 are metallised so that the reflector frame 10 can be used as an aperture-type antenna. For this reason, this part may be provided with a metal coating, or the cast reflector frame part may include electrically conductive particles embedded in a host material in such a way that the cast part is electrically conductive in at least the surface region. This is necessary in order to facilitate the use of the interior section 16 as an antenna aperture for the radiating element 20 and for providing a well defined, shielded enclosure in conjunction with a suitable adapter 50, as explained further below.

The reflector frame 10 enclosed by the circumferential walls 12 has two openings: an upper horizontal opening 11 and a lower horizontal opening 17 facing the metal plane 31. One can observe from Fig. 2A and also from successive figures that the interior section 16 enclosed by the sidewalls 12 is divided by the support structure 13 and the radiating element 20 into two separate cavities, the upper open cavity 16.2 and the back reflector cavity 16.1 (cf. Fig. 2C). As explained above for a preferred embodiment of the invention, but not restricted to the same, the arrangement of slots within the electrically conducting sheet 26, or an equivalent planar structure, may be used for providing mode conversion within the area 23.1 to efficiently exchange electromagnetic energy between the coplanar waveguide 27 and the fundamental waveguide mode corresponding to the cross-section of opening 11. The back reflector cavity 16.1 in conjunction with the planar structure constitutes a hybrid resonator with its resonant frequency approximately tuned to the center of the useful impedance matching bandwidth. The slot arrangement is optimized in view of the fundamental waveguide mode excitation and unwanted field components suppression in the radiating aperture 11. The upper open cavity 16.2 may be very shallow. In this case, the radiating element 20 is directly coupled to the free space. However, a certain minimum height of the open cavity 16.2 provides for additional degrees of freedom for obtaining a wide useful frequency bandwidth and a flat frequency response of the antenna gain. It also better supports the formation of a shielded and reproducible interconnect (EM2 and M2 in Fig. 1C) when the adapter 50 is in place. Due to the fact that preferably a cast reflector frame 10 is used, the back reflector cavity 16.1 can have a size and shape different from the one of the open portion 16.2. The dimensions and the shape of this open portion 16.2 have an impact on the radiation pattern of the overall antenna. Thus, according to the desired radiation pattern, the parameters of the open portion 16.2 can be adjusted, e.g. by performing structural optimization based on full-wave electromagnetic simulation methods.

Fig. 2B shows a perspective bottom view of the antenna device 100, where the lower horizontal opening 17 and the bottom of the antenna substrate 21 of the radiating element 20 are clearly visible. This figure further illustrates the way the radiating element 20 is mounted into the reflector frame 10, by inserting it through the lower horizontal opening 17 before the antenna 100 is fitted on the metal plane 31. This figure also shows the separation into two portions of the interior section 16, discussed in the previous paragraph (back reflector cavity 16.1 and open portion 16.2).

A side view of the planar antenna device 100, as mounted on the common substrate 30, can be seen in Fig. 2C. This figure shows the structural components of the assembly. First, a common substrate 30 fitted with the horizontal metal plane 31 may be provided, preferably a low frequency board,. This metal plane 31 is part of the electromagnetic back reflector structure and is provided to enclose the back reflector cavity 16.1 of the reflector frame 10. On this metal plane 31 the reflector frame 10 is fitted with the radiating element 20, that was, in turn, previously fitted inside. Preferably, an electrically conducting connection is provided between the sidewalls 12 of the reflector frame 10 and the metal plane 31. In the depicted embodiment of the present invention, the antenna substrate 21 of the radiating element 20 is suspended by the support structure 13 at a predetermined distance D from the metal plane 31.

Fig. 2C also illustrates the way the feedpoint section 24 (preferably a bendable cantilever) of the radiating element 20 extends from the reflector frame 10 through the lateral opening 14 in one of the vertical sidewalls 12.

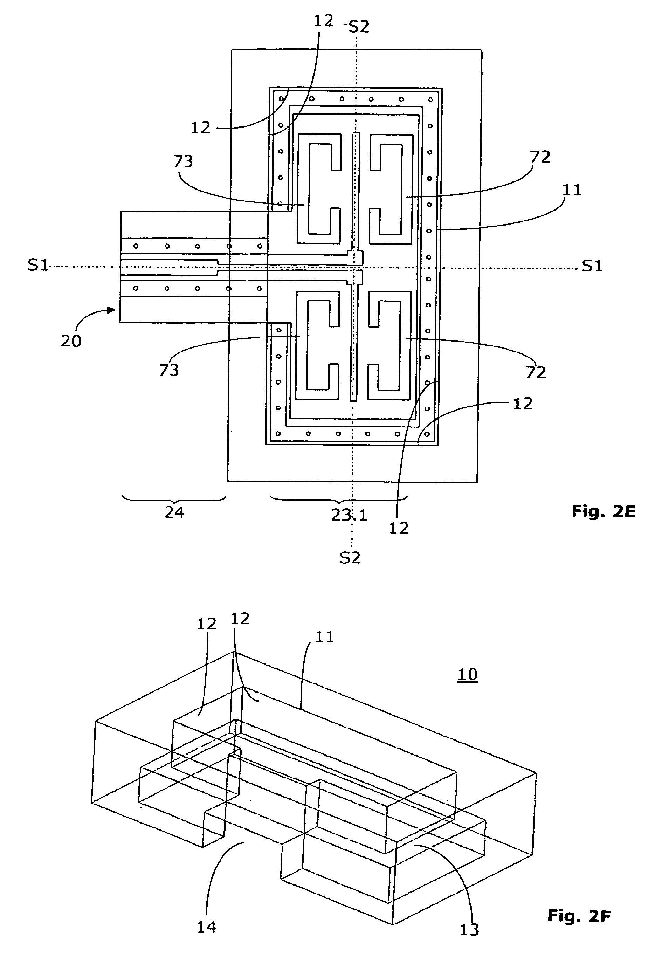

Fig. 2E shows a bottom view of a preferred embodiment of the planar antenna device 100. The above-mentioned fundamental waveguide mode excitation and unwanted field component suppression can best be obtained by incorporating at least one symmetry plane that is common to the feedpoint section 24 and the mode conversion area 23.1, as depicted by S1-S1 in Fig. 2E. Further improvement can be achieved by introducing another local symmetry plane, S2-S2, of the area 23.1. This corresponds to identical slot pairs 72 and 73, respectively.

The radiating element 20 used in the modular antenna device 100 of the present invention is depicted in Fig. 2D. This element 20 is built on an antenna substrate 21. In a preferred embodiment, this substrate 21 is made of a flexible, dielectric material. It is, for instance, a high definition Liquid Crystal Polymer (LCP) flex substrate. In the depicted embodiment, the antenna substrate 21 has a T shape, with a feedpoint section 24 and a mode conversion area 23.1. Beyond the above-mentioned slots 71, 72 and 73, the coplanar waveguide 27, the center conductor 28 and the ground conductors 29, it shows an electrically conducting frame-shaped sheet 74 which is placed on the substrate surface opposed to the one carrying the electrically conducting sheet 26. Both sheets 26, 74 are preferably connected by the use of multiple electrically conducting via connections 75. This arrangement is especially useful when the sheet 26 is oriented towards the metal plane 31 and hence towards the upper surface of the planar circuit 40. This may be desirable in order to avoid critical transitions between the coplanar waveguides on opposite sides of the substrate 21. In this case, sheet 26 is indirectly connected to the supporting structure 13 with the help of multiple electrically conducting via connections 75 and frame-shaped sheet 74, averaging out the influence of individual position tolerances. The feedpoint section 24, which is protruding from the lateral opening 14, may be equipped with an electrically conductive sheet 76 adhering to the substrate surface opposite to the coplanar waveguide 27 in order to provide improved shielding and increased transmission line impedance range. Two lines of electrically conductive via connections 79 between conductive sheet 76 and coplanar ground conductors 29 provide for appropriate shielding of the feed lines 25 and are preferably arranged equidistant to the symmetry plane S1-S1.

Fig. 2F illustrates one suitable embodiment of a reflector frame 10 that can be used on connection with the embodiment illustrated in Figures 2A -2E.

The feedpoint section 24 is meant to extend from the reflector frame 10 through the lateral opening 14 and has the role of enabling the mechanical and electrical connection (interfaces E1 and M1) of the radiating element 20 to other components via feed lines 25. The feedpoint section 24 is realized as cantilever and it may feature flip-chip contacts near its outer edge. Preferably, a bendable cantilever serves as feedpoint section 24 so as to provide a compliant interface to the planar circuit 40 (cf. Fig. 3). The cantilever or bendable cantilever can be used in connection with all embodiments.

In another preferred embodiment, the entire substrate 21 (not only the cantilever part) is a flexible substrate. In this case, the reflector frame 10 provides for sufficient mechanical stability against so-called microphony (being the modulation of electrical signals by acoustically induced periodic displacements) and/or thermally induced bending or warping. The flexible substrate can be used in connection with all embodiments, too.

The electrically conducting plane 31 is part of back reflector cavity 16.1 and it may serve as ground contact. The conducting plane 31 may be either a part of the planar antenna device 100 for better reproducibility, or it may be part of substrate 30 for lower cost. If the plane 31 is part of the substrate 30, then it also serves as mechanical support for the planar antenna device 100.

An exemplary first embodiment of a communications system 200, which comprises a planar antenna device 100, as mounted on a common substrate 30, is shown in Fig. 3. Besides the planar antenna device 100, the common substrate 30 usually accommodates other electronic components like an integrated circuit 40 (planar circuit or active circuit 40), as depicted in this figure. A number of peripheral surface contacts 41 are being connected to the printed circuit board or common substrate 30 using for instance bond wires. According to the present invention, (peripheral) bond pads 41.1 constituting the millimeter wave port(s) of the circuit 40 are being connected directly to the feedpoint section 24 via feed lines 25 (cf. Fig. 2D) at its outer edge. A preferred process for establishing such direct connection is inverse flip-chip bonding, involving thermosonic welding of feed lines 25 to gold-plated or mechanically bumped surface contacts 41.

Operating at other frequency bands not being excluded, the present invention is particularly suited to operate in the 57 to 66 GHz or the 71 to 86GHz frequency ranges, respectively. The planar antenna device 100 at the same time is meant to be used mainly for indoor communication. Also the so-called "full-duplex" simultaneous two-way communication is possible using the planar antenna 100, provided that an additional diplexer is employed between antenna device 100 on one hand, and receive- and transmit ports of circuit(s) 40, respectively.

The radiation efficiency of the antenna device 100 may be well beyond 90%, which coincides with a low loss operation of the waveguide transition (insertion loss of a few tenths of a dB). Also by design, the device 100 is very robust, meaning it presents a low sensitivity to the manufacturing tolerances, allowing using a relatively low cost subtractive etching process instead of thin-film process that requires additive conductor formation.

The reflector frame part 10 of the present invention is designed so that an adaptor 50, as it is depicted on Fig. 4, can be attached. To facilitate the attachment of the adaptor 50, the reflector frame and/or antenna device 100 comprises the interfaces EM2 and M2 (cf. Fig. 1C).

This adaptor 50 is designed to be connectable to the upper horizontal opening 11 of the antenna device 100. The purpose of the adaptor 50 is to provide a possibility to connect various testing and tuning equipment to the modular antenna device 100 (e.g. via a waveguide element 400, as illustrated in Fig. 1D) or to connect an antenna 500 (as illustrated in Fig. 1E). The antenna 100 together with the adaptor 50 provides a respective planar-circuit-to-waveguide transition. Both parts 100 and 50 form a fully shielded interface between a planar circuit (e.g. the planar circuit 40) and a waveguide (e.g. the waveguide element 400) when connected together.

For this reason, the upper portion 52 of the adaptor 50 has a shape adapted to the particular testing or tuning equipment used. The lower portion (male portion) of the adaptor 50 has a form factor so that the male part fits into the antenna 100. The adaptor's male portion is designed so that a mechanical contact to the antenna frame 10 is provided (this mechanical connection is referred to as interface M2). Preferably, a galvanic contact is established between the parts 10 and 50 when the adaptor 50 is plugged into the antenna 100, thereby providing full electromagnetic shielding.

The body of the adaptor 50 provides for a mechanical connection to the frame 10 on one side (interface M2) and a mechanical connection (interface M3) to the (test equipment) waveguide element 400 on the other side. The body further comprises features/elements which ensure a near-field modification inside the otherwise open cavity 16.2 (interface EM2) when an electro-magnetic wave is coupled from the reflector frame 10 into the waveguide 400. At least part of the adaptor's surface is conducting. In the context of the present invention, a near-field modification shall denote a well-defined manipulation of the electromagnetic boundary conditions close to the mode conversion area 23.1 (or 23.2). It is reproducibly introduced when the adaptor 50 is engaged with the frame 10, and absent when the antenna 100 is in normal operation.

According to the present invention, the adaptor 50 provides for a waveguide transition (e.g. to a standard WR-15 waveguide in case of V-band, interface EM3) which is required for an adequate testing environment, also ensured by the robustness and tolerance insensitivity of the connection between the reflector frame 10 and the adaptor 50. In order to be able to provide the required transition, a highly efficient, high bandwidth coupling to a waveguide interface (EM3) is rendered possible by a modification of the antenna near-field.

Similarly to the reflector frame 10, the adaptor 50 may also be a (pre-) cast part, but the adaptor 50 can also be made by milling, drilling and other conventional processes. Please refer to the previous discussion about cast parts for details of the casting methods and alternatives. The cast reflector frame 10 together with the cast adaptor 50 provides for a direct connection between a planar circuit 40 and a waveguide interface. Both parts 100, 50 cooperatively provide for a desired impedance transformation.

Compatible to low cost, high volume manufacturing technologies are employed, according to the present invention, when intended to be used as transition inside a communication product or system 200, e.g. with a waveguide-based high gain antenna 500 or filter. However, their application is not a must for attaching test and measurement adapters that are needed in smaller numbers.

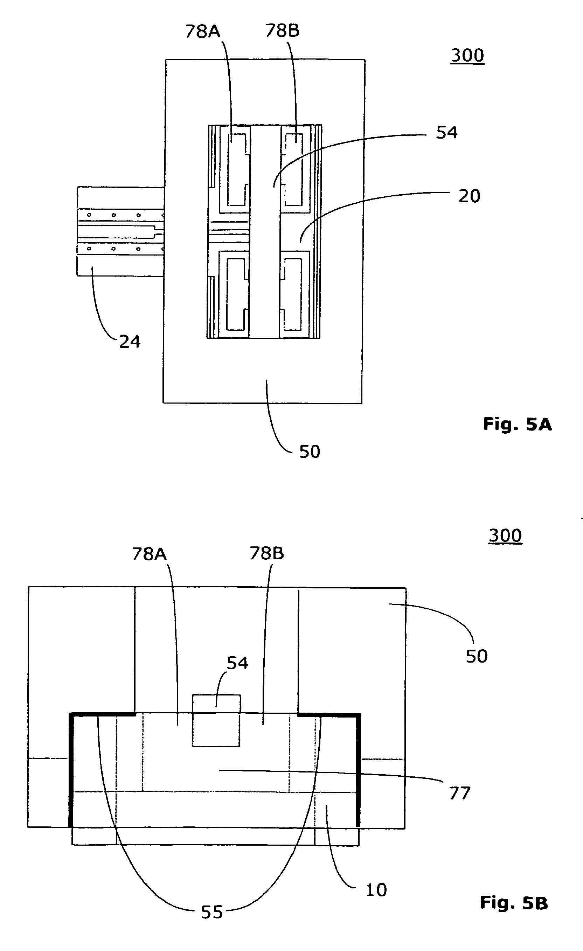

In Fig 4, a suitable element for modifying the near field of the mode conversion area 23.1 (cf. Fig. 2E) of the first embodiment is depicted which takes the shape of an electrically conducting transversal ridge or rod 54. This element is permanently attached to adaptor 50 i.e. it is an integral part of it. A gap 77 (cf. Fig. 5B) is provided between the lower face of element 54 (which faces substrate 21) and the electrically conducting sheet 26 (cf. Fig. 2D) in order to avoid a direct short-circuit of the primary slot 71. Depending on the location of sheet 26 (top or rear face of substrate 21) the gap 77 may be filled with air or with the combination of air with dielectric substrate. In an advantageous embodiment, element 54 is shaped and positioned symmetrical to plane S2-S2 (cf. Fig. 2E). In a further preferred embodiment, element 54 is shaped symmetrical to plane S1-S1 (cf. Fig 2D). Shape and arrangement of the element 54 are preferably chosen to support a fundamental waveguide mode (e.g. the TE10 mode) inside the segments 78A and 78B of the remaining aperture (cf. Fig. 5A). Transversal and longitudinal dimensions of these segments 78A, 78B are purposefully chosen to support the desired impedance transformation while the electromagnetic fields of undesired modes are displaced sufficiently to shift the corresponding resonance frequencies out of the desired bandwidth of operation.

To ensure a proper mechanical alignment of the adaptor 50 and the reflector frame 10, spring contacts, surface contacts, nut/bolt connections, or the like may be employed as mechanical interface M2. The same elements may be used to provide for the electromagnetic contact (interface EM2) between the reflector frame 10 and the adaptor 50. It is conceivable to employ different elements for the mechanical and the electromagnetic connection, respectively.

In order to provide for a transition to a waveguide element 400, the adaptor 50 may comprise a standard waveguide flange (e.g. WR-15 in case of operation inside V-Band).

In a preferred embodiment, as depicted in Fig. 5B, the adaptor 50 and the frame 10 form both an electrical and a mechanical contact 55 when connected. The upper horizontal opening 11 of the reflector frame 10 and the adaptor 50 can be galvanically connected e.g. at the horizontal front face of frame 10, encompassing opening 11, thus creating a fully shielded waveguide transition. The horizontal part of the contact area 55 provides for a precise vertical stop position while the vertical parts may provide for precise lateral (x, y, theta) alignment between reflector frame 10 and adaptor 50. In Fig. 5B, the above-mentioned gap 77 can also be seen. Element 54 may or may not have lateral mechanical and/or electrical contact to the inner sidewalls 12 of back reflector frame 10.

The planar antenna device 100 fitted with the adaptor 50 supports fully calibrated test environments suitable for manufacturers who need to test and fine-tune their equipment, namely the planar circuit 40, in a reliable and reproducible manner.

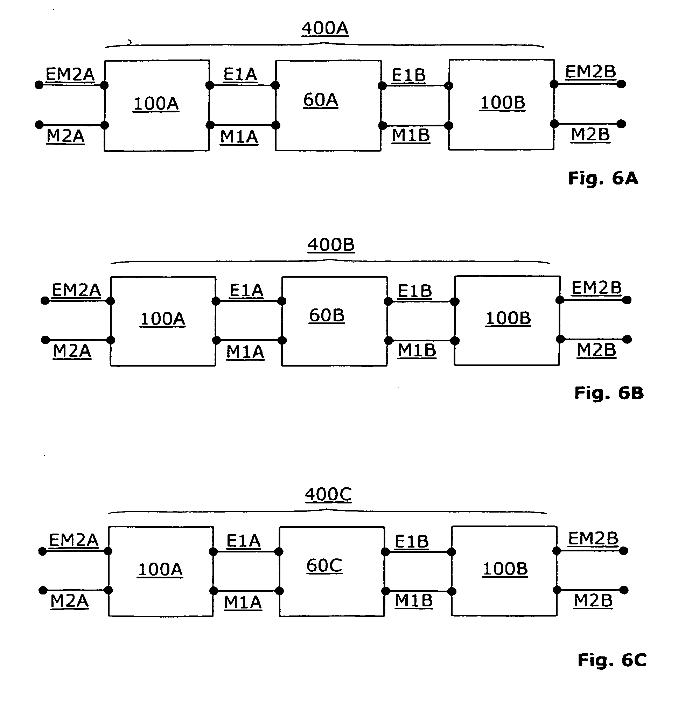

Due to the high degree of reproducibility of the antenna-to-adaptor mating, calibration kits can be defined. Fig. 6A depicts an arrangement of a first antenna device 100A, a first calibration standard 60A and a reversed second antenna device 100B. The calibration standard 60A preferably has the same electrical and mechanical port configuration(s) E1, M1 as the planar circuit 40 in the product application arrangements, described herein. The calibration standard 60A may e.g. represent a direct through connection. The ladder network of Fig. 6A is also referred to as calibration standard 400A, comprising antenna devices 100 as detachable ports.

Fig. 6B depicts an equivalent arrangement with the first calibration standard 60A replaced with a second calibration standard 60B. The calibration standard 60B may e.g. represent a so-called "LINE" standard which has a well-defined extra length of interconnect transmission line between antenna devices 100A and 100B. The ladder network of Fig. 6B is also referred to as calibration standard 400B.

Fig. 6C depicts a third arrangement with the third standard 60C inserted. This standard may be viewed as so-called "REFLECT" standard that provides for equal large reflections to antenna devices 100A and 100B, while providing a high degree of electrical signal isolation between the two. The ladder network of Fig. 6C is also referred to as calibration standard 400C. A 2-port Vector Network Analyzer (VNA) may be used for fully calibrated measurements. Its measurement ports can be equipped with one appropriate adaptor 50 each. Sequential measurements of the calibration standards 400A, 400B and 400C provide for a set of measurement data allowing computation of the error coefficients of e.g. the well-known 12-term error model that can be used to mathematically remove the imperfections of the physical measurement set-up including transitions to interfaces E1, M1, as described by S. Rehnmark in "On the calibration process of automatic network analyzer systems," IEEE Trans. on Microwave Theory and Techniques, April 1974, pp. 457 - 458, and by J. Fitzpatric in "Error models for systems measurement," microwave Journal, May 1978, pp. 63 - 66.

Another well-known method can be applied to determine the scattering matrix of the arrangement 300 (cf. Fig 1C) by using the above-mentioned error coefficients and the corresponding ones obtained from calibrating the VNA at its standard waveguide ports. Since this arrangement 300 constitutes the composite adaptor between standard waveguide (interfaces EM3, M3) and planar device port (interfaces E1, M1), the knowledge of this scattering matrix is very useful to correct measurements done with equipment that has known properties with respect to standard waveguide ports but does not support calibration of nonstandard ports.

In a preferred embodiment, the adaptor 50 and the reflector frame 10 are designed so that the adaptor 50 can be attached and detached manually. A mechanical clamping mechanism is thus preferred.

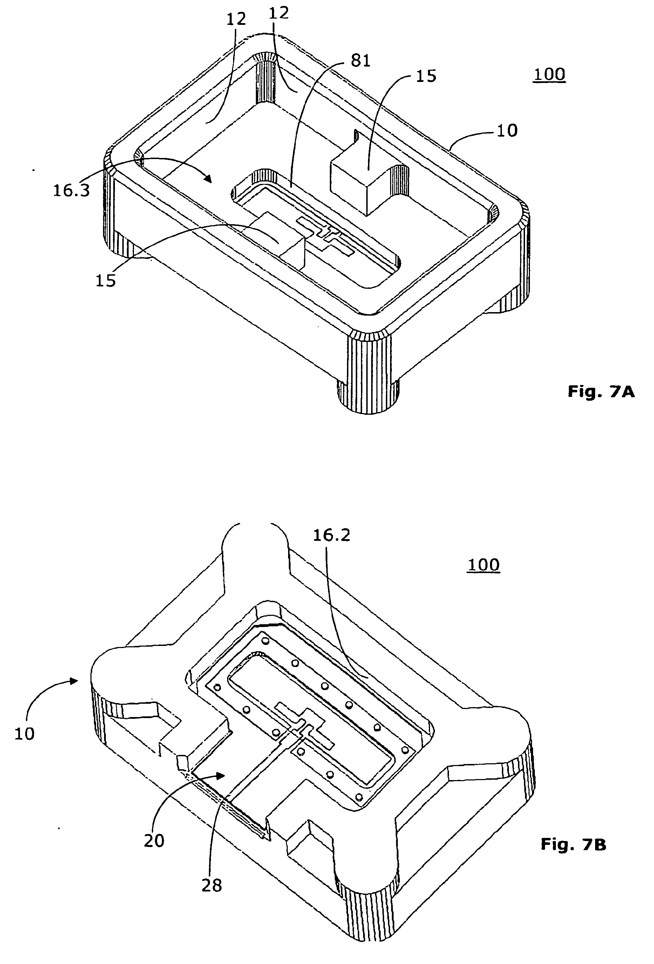

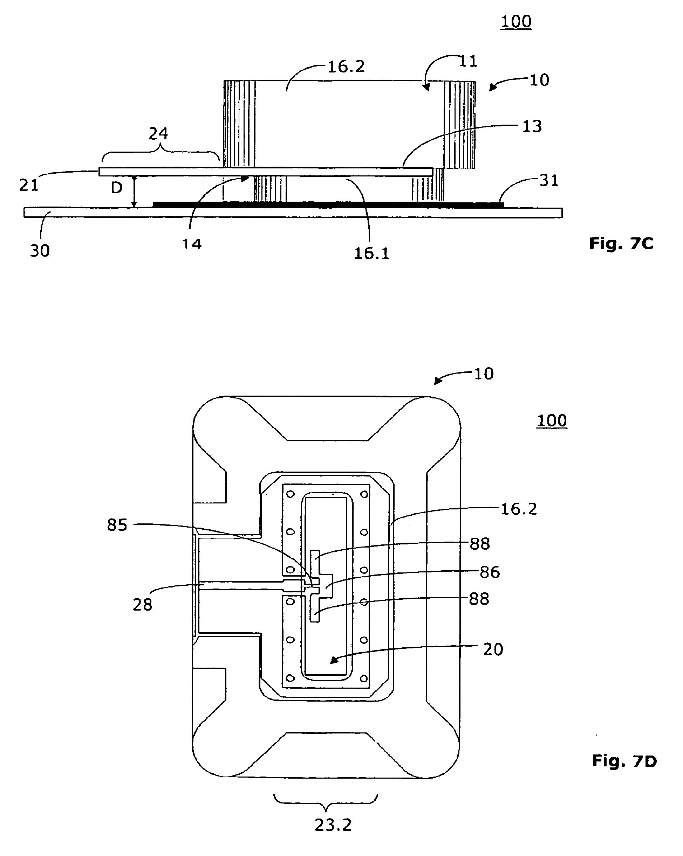

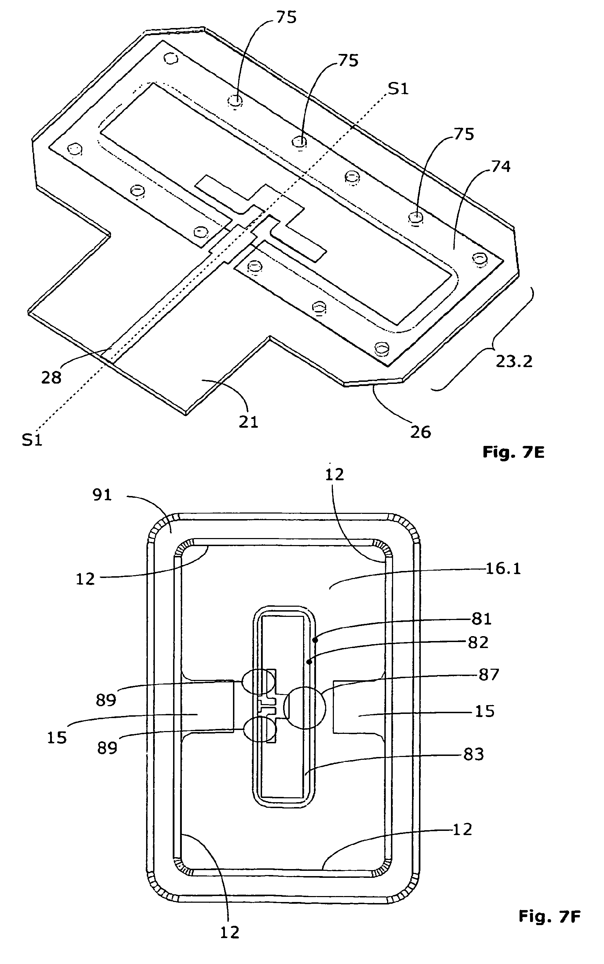

In a further embodiment, an open cavity antenna may be devised with an alternative mode conversion area 23.2 (cf. Fig. 7D) that serves as radiating element 20 of a planar antenna device 100 with increased aperture size and thereby increased antenna gain capability. A respective embodiment is illustrated in Figures 7A through 7F. The same reference numbers are used for the same elements as well as for elements which have more or less the same function. The respective elements are only briefly addressed. Further details can be derived from the description of Figures 2A through 2F.

This embodiment is characterized by the fact that the open upper cavity 16.2 (cf. Fig. 7D) and the lower back reflector cavity 16.1 are separated by a horizontal shielding wall 16.3 (cf. Fig. 7A) which is preferably an integral part of the reflector frame 10. Said shielding wall 16.3 comprises a 2-fold mirror-symmetrical aperture 81 which is centered within the open upper cavity 16.2. The shielding wall 16.3 is herein also referred to as support structure, since it is designed so as to receive or hold the radiating element 20. The back reflector cavity 16.1 (cf. Fig. 7D) covers preferably a much smaller area than the open upper cavity 16.2, thereby diminishing the number of its resonant modes within the frequency range of operation. The radiating element 20 (cf. Fig. 7B) is placed on the lower face of shielding wall 16.3 and comprises a mode conversion area 23.2 that is essentially confined to the aperture 81 (cf. Fig. 7A).

In a preferred embodiment, the aperture 81 is dimensioned for supporting only one fundamental resonant mode within the frequency range of operation.

An advantageous embodiment comprises an essentially rectangular aperture 81. The mode conversion area 23.2 takes the form of a modified E-probe. Since the height of the back reflector cavity 16.1 is given by the circuit 40 (e.g. a SiGe chip), it can not be used as a free electrical design parameter. In the 60GHz range, the typical chip height of 500 µm represents only ca. 30% of the usual depth of the backshort section in an E-probe based planar circuit-to-waveguide transition, being approximately a quarter-wave length, see e.g. S. Hirsch, K. Duwe, and R. Judaschke "A transition from rectangular waveguide to coplanar waveguide on membrane," Infrared and Millimeter Waves, 2000. Conference Digest. 2000 25th International Conference.

The modified E-probe is fed by a center conductor 28, which itself is fed by a feedline 25 comprised in a feedpoint section 24 in analogy to the previously described embodiment (cf. Fig. 2A - 2F, Fig. 7C). For sake of clarity, section 24 is omitted in Fig. 7A, 7B and Fig. 7D - 7F. The center conductor 28 is attached to one surface of substrate 21, opposed to a large area, electrically conducting sheet 26, which serves as electrical ground layer. In correspondence to the shape and size of aperture 81, an opening 82 is provided within sheet 26, which preferably resembles the outskirt of aperture 16.3, but having slightly smaller dimensions. The resulting protruding conductor frame helps to reduce the influence of positioning tolerances between frame 10 and radiator element 20.

In a preferred embodiment, a ring-shaped, electrically conductive sheet 74 is provided and is placed on the same surface of substrate 21 as the center conductor 28. It comprises an opening 83 of 2-fold mirror symmetrical shape, which lies entirely within opening 82. In analogy to the first embodiment of planar antenna device 100, multiple electrically conducting via connections 75 may be used for ensuring identical electrical potentials on sheets 26 and 74. The center conductor 28 protrudes from the electrical ground layer into the opening 82, where it takes the form of a preferably narrow strip 85 (cf. Fig. 7D). Due to the absence of the ground layer in this area, this strip represents a series-connected inductive reactance. Strip 85 is connected to a wider patch 86, leaving a gap 87 (cf. Fig. 7F) between itself and the opposite edge of opening 83. Thanks to the placement of both conductive sheet 74 and patch 86 on the same side of the substrate 21, the stray capacitance produced by gap 87 is mostly independent of positioning tolerances (slight placement errors) that result from the sequential exposition during the photolithographic production process of radiator 20; provided the opening 83 stays within opening 82. Additionally, the reduced sensitivity against positioning tolerances of radiator 20 referred to aperture 81 is obtained by providing sufficient lateral spacing between the conductor edge enclosing the opening 82 and the outskirt of aperture 81.

A preferred embodiment of the mode conversion area 23.2 provides the mirror-symmetrically arranged, electrically conductive, transverse strips 88, which are connected to the sides of patch 86 and running approximately parallel to the conductor of opening 82. A distance to the edge near center conductor 28 is much smaller than to the far edge. This modification of the well-known E-probe arrangement compensates for the unusual small height of back reflector cavity 16.1, reestablishing a good and broadband impedance matching both for the antenna and waveguide transition operation mode. The arrangement with stray capacitances established by gaps 87 and 89, respectively establish a quasi-lumped element capacitive voltage divider. This simple and compact structure allows for impedance matching bandwidth sufficing for Gigabit modulated RF waveforms and for a full waveguide-band (e.g. V-band 50 - 75GHz) operation of the waveguide transition i.e. test and measurement operation mode. The elimination of planar reactance matching networks in the planar feedpoint section significantly reduces the millimeter wave insertion loss.

In an advantageous embodiment of open cavity 16.2, two pedestals 15 are provided which each have the same mirror symmetry S1-S1 as the mode conversion area 23.2. They are also identical and as such establish a second, local mirror symmetry plane. The height of pedestals 15 is less or equal to the height of cavity 16.2 and their width and length are adjusted to obtain optimized broadband impedance matching properties for the antenna mode operation. It is advantageous to adjust the width of pedestals as to obtain optimized matching with a pedestal length of between 50% and 90% of the distance between the inner sidewall 12 of cavity 16.2 and the edge of aperture 81. With the help of pedestals 15, good aperture efficiency for the radiation from upper opening 11 can be achieved, i.e. a good compromise between matching bandwidth and near-uniform aperture fields can be found.

For providing a reproducible high frequency contact to an adaptor 50, at least the shielding wall 16 and the inner sidewalls 12 of upper cavity 16.2 are electrically conductive, e.g. by coating with a thin metallic layer.

In a further preferred embodiment, the front face 91 of the upper cavity 16.2 is also electrically conducting with circumferential contact to the inner sidewalls 12 and exhibits an essentially flat surface.

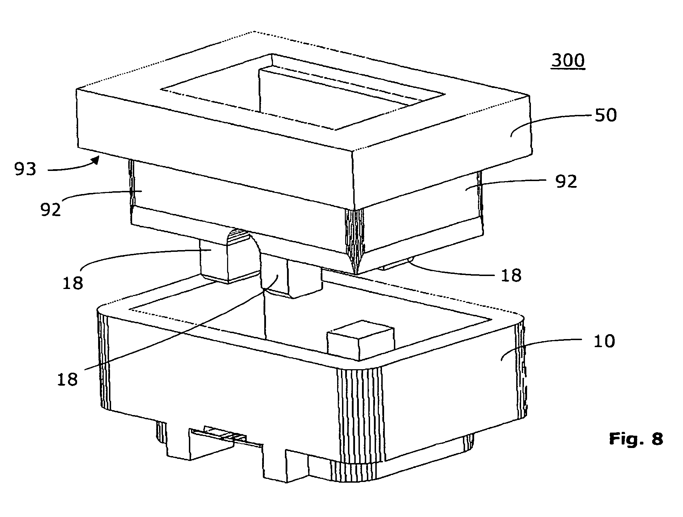

In Fig. 8 a perspective view of an arrangement comprising a planar antenna device 100 according to the present invention and an adaptor 50 is shown. This figure illustrates how the adaptor 50 can be plugged into the antenna 10. The reflector frame 10 may be completely or partially metallized as described above, while the adaptor (frame) 50 is completely metallized. When being mounted, the two elements 10, 50 are galvanically connected and a fully shielded waveguide transition is created. The galvanic contact is preferably established in either of the following two ways. If the inner sidewalls 12 of the upper cavity 16.2 of frame 10 provide sufficient surface flatness, accurate enough dimensions and conductor abrasion resistance, a lateral contact with outer sidewalls 92 of adaptor 50 is established. In this case, at least the sidewalls of frame 10 have to possess certain mechanical compliance and elasticity. Otherwise, the lower protruding circumferential front face 93 of adaptor 50 can be used to establish a galvanic contact with the metallized front face 91 along the flange perimeter. As illustrated in Fig. 8, symmetrically arranged electrically conductive posts 18 may be provided in order to establish the inventive near-field modification of the present embodiment of antenna device 100 and to provide a suitable impedance transformation in the waveguide transition mode of operation. Preferably they are not touching the inner sidewalls 12 and the shielding walls 16 in order to avoid mechanical ambiguity and to mitigate inadvertent damage of their highprecision surfaces.

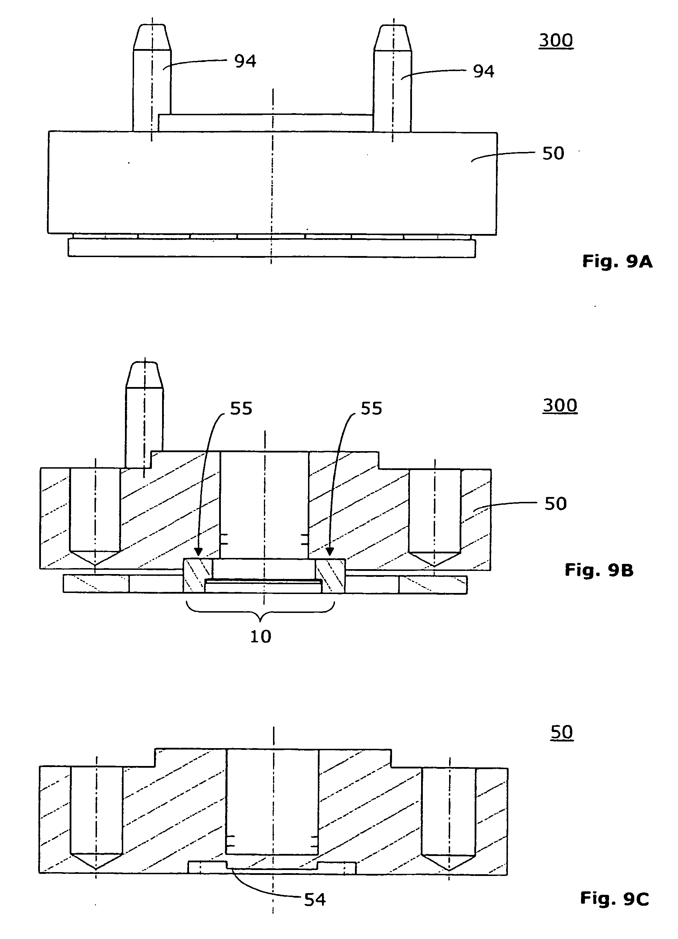

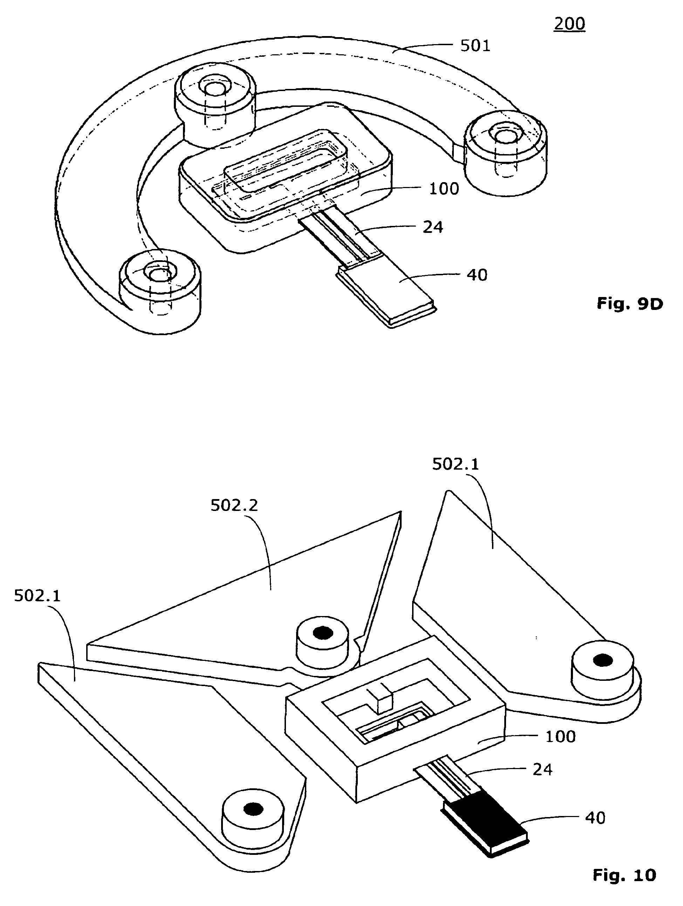

Figures 9A through 9D illustrate an arrangement 300 composed of the first preferred embodiment of planar antenna device 10 and fitting adaptor 50. A standard waveguide flange with alignment pins 94 is implemented as mechanical interface M3 and electromagnetic interface EM3, respectively. Fig. 9A shows a side view, while Fig. 9B shows an off-center cross-section through the arrangement. The contact areas 55 (cf. Fig. 5B) can be clearly recognized. Fig. 9C shows only a cross-section through the center plane of adaptor 50. The transversal ridge 54, establishing the combined inventive near-field modification and impedance matching functions, can also be seen. In Fig. 9D, a communication system 200 is shown where the antenna device 100 is connected to an active device 40. A mechanical support structure 501 is shown which can be used for mechanical fixing of the adaptor 50 to the common substrate 30 with the help of screws. In this way, a safe and space-saving method of attaching test waveguides for measurement purposes in the laboratory environment is provided. The mechanical support structure 501 is a part of mechanical interface M2 in this special configuration. It can be glued, soldered or screwed to the surface of common substrate 30. In the production test environment the mechanical support structure 501 can be omitted by providing precise alignment and sufficient contact force with an automatic probe handling system.

Yet another embodiment of a communication system 200 (with modified E-probe design) is shown in Fig. 10. Here the mechanical support structure, which is part of the mechanical interface M2 is separated into three individual parts 502.1 (2x) and 502.2, that are made of a material and are furnished with a surface plating optimized for surface mount technology (SMT) and for a reflow solder process. In this way, the elements needed for permanently attaching an additional component, like e.g. a high-gain antenna 500 can be cost-effectively mounted using an automatic fabrication process. Instead of using screws, spring-action clamps, bayonet joints or other methods can be used with appropriately shaped mechanical support elements.

According to the invention, the antenna 100 can be attached to a circuit 40 and can either be used alone, without connection to the adaptor 50, or connected to the adaptor 50.

In unconnected configuration, the antenna 100 is a low-loss, wide bandwidth, high efficiency component of a communication system 200 with medium gain, easily mounted on a standard substrate 30 and connected to a circuit 40.

In connected configuration, the waveguide interface EM3, M3 provides the possibility to add active and passive components to the circuit 40 including, but not limited to, filters, high-gain antennas and amplifier modules. The adaptor 50 preferably provides for a field modification (e.g. for suppressing unwanted resonant modes) which enables the connection of a waveguide 400 or antenna 500 to the antenna device 100.

Also in connected configuration, the waveguide interface EM3, M3 allows for a low loss, a fully shielded, reproducible test and measurement environment for the circuit 40 within the full operation bandwidth of standard waveguide components 400.

The inventive antenna device 100 and adaptor 50 are co-designed to simultaneously fulfill their specific function both in connected and in unconnected configuration.

All elements, especially the antenna device 100, are designed to be fabricated using standard, low cost materials and establish high volume manufacturing processes. Low-volume technologies, like CNC machining, are not precluded, molding is a preferred technology but for larger quantities.

As a result, a modular and very flexible solution is available that allows to build cost effective modules comprising the present antenna device 100, is adapted for test and measurement in production and design sequences. It is equally well suited to accommodate active and passive components with waveguide interfaces. A unified interface of this kind allows for further reduction the overall production cost by minimizing the number of necessary module versions, lessening the logistic efforts and increasing stock turnover.

Compared to existing solutions, the present invention significantly reduces the cost of millimeter wave transmitter and receiver circuits and modules in particular.
The following table is an integral part of the description

| | |
|---|---|
| reflector frame | 10 |
| upper horizontal opening | 11 |
| circumferential side walls | 12 |
| support structure | 13 |
| lateral opening | 14 |
| pedestals | 15 |
| interior section | 16 |
| back reflector portion / back reflector cavity | 16.1 |
| open portion / open cavity | 16.2 |
| Shielding wall | 16.3 |
| lower horizontal opening | 17 |
| Stubs | 18 |
| radiating element / mode conversion element | 20 |
| (antenna) substrate | 21 |
| radiating patterns | 22 |
| | 23 |
| mode conversion area (active area) | 23.1 |
| Alternative mode conversion area | 23.2 |
| Feedpoint (section) | 24 |
| feedlines | 25 |
| electrically conductinq sheet | 26 |
| coplanar waveguide | 27 |
| centre conductor | 28 |
| ground conductors | 29 |
| common substrate | 30 |
| horizontal metal plane | 31 |
| integrated circuit | 40 |
| Contacts (bond wires) / surface contacts | 41 |
| Bond pads | 41.1 |
| | |
| Adaptor | 50 |
| lower portion | 51 |
| upper portion | 52 |
| first mating element | Not shown |
| second mating element (ridge or rod) | 54 |
| | 55 |
| first calibration standard | 60A |
| Second calibration standard | 60B |
| Third calibration standard | 60C |
| | |
| (primary) slot | 71 |
| slot | 72 |
| slot | 73 |
| frame-shaped sheet | 74 |
| connections | 75 |
| electrically conductive sheet | 76 |
| gap | 77 |
| segment | 78A |
| segment | 78B |
| connections | 79 |
| mirror-symmetrical aperture | 81 |
| opening | 82 |
| opening | 83 |
| narrow strip | 85 |
| wider patch | 86 |
| gap | 87 |
| transverse strips | 88 |
| gap | 89 |
| | |
| Front face | 91 |
| outer sidewalls | 92 |
| circumferential front face | 93 |
| alignment pins | 94 |
| | |
| | |
| Modular antenna device | 100 |
| first antenna device | 100A |
| reversed second antenna device | 100B |
| Arrangement | 300 |
| waveguide element | 400 |
| calibration standard | 400A |
| calibration standard | 400B |
| calibration standard | 400C |
| antenna | 500 |
| mechanical support structure | 501 |
| individual parts | 502.1 |
| individual part | 502.2 |
| | |
| Interface / electromagnetic contact | EM2 |
| Electromagnetic interface | EM2A |
| Electromagnetic interface | EM2B |
| interface / waveguide interface | EM3 |
| electric interface | E1 |
| electric interface | E1A |
| electric interface | E1B |
| Mechanical interface | M1 |
| Mechanical interface | M1A |
| Mechanical interface | M1B |
| Mechanical interface | M2 |
| Mechanical interface | M2A |
| Mechanical interface | M2B |
| Mechanical interface | M3 |
| | |
| Symmetry line | S1 |
| Symmetry line | S2 |

## Claims

1. Surface-mountable antenna device (100; 100A; 100B) comprising
- a reflector frame (10) having
○ circumferential sidewalls (12) providing for a lateral definition of an interior section (16),
○ a lateral opening (14) in one of said sidewalls (12),
○ an upper horizontal opening (11) serving as electromagnetic aperture,
○ a lower horizontal opening (17), and
○ a support structure (13; 16.3) being an integral part of said reflector frame (10),
- a radiating element (20) having
○ a planar, horizontally oriented antenna substrate (21) with a mode conversion area (23.1; 23.2) and with a cantilever-shaped feedpoint (24) protruding from said mode conversion area (23.1; 23.2) in an essentially horizontal direction,
wherein said feedpoint (24) extends from said interior section (16) through said lateral opening (14) in order to be able to provide for a connection to an active circuit (40),
wherein said antenna device (100; 100A; 100B) is mounted on a common substrate (30) with a metal plane (31),
and
wherein said reflector frame (10) comprises metal or is at least partially metallised,
**characterized in that:**
- said radiating element (20) is mounted by said support structure (13; 16.3) inside said interior section (16) so that said interior section (16) is divided into a back reflector cavity (16.1) and an open portion (16.2);
- said reflector frame (10) carrying said radiating element (20) inside is mounted on top of said horizontal metal plane (31), and
- a portion (16.1) of said interior section (16) between said antenna substrate (21) and said metal plane (31) is configured to serve as back reflector cavity (16.1) for said electromagnetic waves, said metal plane (31) acting as a back reflector for the radiating element (20).

2. The antenna device (100; 100A; 100B) of claim 1 comprising
- said common substrate (30) with a metal plane (31),
- said active circuit (40),
- electrical connections (E1) between said active circuit (40) and said feedpoint (24).

3. The antenna device (100; 100A; 100B) of claim 1 or 2, comprising an electromagnetic interface (EM2) and a mechanical interface (M2) for establishing a connection to an adaptor (50).

4. The antenna device (100; 100A; 100B) of claim 3, wherein said mechanical interface (M2) provides for a plug-in connection to said adaptor (50).

5. The antenna device (100; 100A; 100B) of claim 3, **characterized in that** it comprises at least one mating element (15) for mechanical engagement with said adaptor (50).

6. The antenna device (100; 100A; 100B) of any one of the claims 1 through 5 being part of a planar circuit-to-waveguide transition.

7. The antenna device (100; 100A; 100B) of claim 1 or 2, wherein at least those sidewalls (12) of said reflector frame (10) which are facing said interior section (16) are metallised.

8. The antenna device (100; 100A; 100B) of claim 2, wherein an electrically conducting connection is provided between said sidewall (12) and said metal plane (31).

9. The antenna device (100; 100A; 100B) of claim 1 or 2, wherein said upper horizontal opening (11) is designed as aperture for the emission of electromagnetic waves emitted by the mode conversion area (23.1; 23.2) of said radiating element (20).

10. The antenna device (100; 100A; 100B) of claim 2, wherein said antenna substrate (21) is suspended by said support structure (13; 16.3) at a distance (D) from said metal plane (31).

11. The antenna device (100; 100A; 100B) of one of the preceding claims, wherein said antenna substrate (21) is made of a flexible, dielectric material.

12. The antenna device (100; 100A; 100B) of one of the preceding claims1 through 9, wherein a high definition liquid crystal polymer flex substrate is used as antenna substrate (21).

13. The antenna device (100; 100A; 100B) of one of the preceding claims, wherein said lower horizontal opening (17) and said antenna substrate (21) have dimensions which allow said antenna substrate (21) to be inserted into the interior section (16) through said lower horizontal opening (17).

14. The antenna device (100; 100A; 100B) of one of the preceding claims, wherein said mode conversion area (23.1) has a rectangular shape and comprises:
- an electrically conducting sheet (26) having at least one slot (71), this slot (71) being preferably placed in a centre of the mode conversion area (23.1), the length of the slot (71) being chosen to be equal to approximately half of the wavelength at the centre of the intended frequency band, and
wherein said feedpoint (24) comprises:
- a coplanar waveguide (27) which is entering said mode conversion area (23.1) approximately at the centre of one of its broader edges, the coplanar waveguide (27) being established by two parallel slots in a thin electrically conducting sheet (26), resulting in a centre conductor (28) and two ground conductors (29).

15. The antenna device (100; 100A; 100B) of one of the preceding claims 1 through 13, wherein said mode conversion area (23.2) takes the form of a modified E-probe.

16. Communication system (200) comprising an antenna device (100; 100A; 100B), according to one or more of the claims 1 - 5, at least one active circuit (40) and a common substrate (30), said active circuit (40) and said antenna device (100; 100A; 100B) being situated on said common substrate (30) and said active circuit (40) being connected via feedlines (25) of said feedpoint (24) to said mode conversion area (23.1; 23.2).

17. The communication system of claim 16, wherein said feedpoint (24) provides for a flexible transition between said active circuit (40) and said mode conversion area (23.1; 23.2).

## Patentansprüche

1. Flächenmontierbare Antenneneinrichtung (100; 100A, 100B) mit
- einem Reflektorrahmen (10) mit
o umfänglichen Seitenwänden (12), die zur seitlichen Definition eines inneren Abschnitts (16) vorgesehen sind,
o einer seitlichen Öffnung (14) in einer der Seitenwandungen (12),
o einer oberen horizontalen Öffnung (11), die als elektromagnetische Apertur dient,
o einer unteren horizontalen Öffnung (17) und
o einer Stützstruktur (13; 16.3), die ein integrales Teil des Reflektorrahmens (10) ist,
- einem abstrahlenden Element (20) mit
o einem planen, horizontal orientierten Antennensubstrat (21) mit einem Moduskonvertierungsbereich (23.1; 23.2) und mit einem Einspeisepunkt (24) in Form eines Auslegers, der aus dem Moduskonvertierungsbereich (23.1; 23.2) in einer im Wesentlichen horizontalen Richtung herausragt,
- wobei der Einspeisepunkt (24) sich von dem inneren Abschnitt (16) durch die seitliche Öffnung (14) erstreckt, um für eine Verbindung zu einer aktiven Schaltung (40) sorgen zu können,
- wobei die Antenneneinrichtung (100; 100A; 100B) auf ein gemeinsames Substrat (30) mit einer metallischen Ebene (31) montiert ist, und
- wobei der Reflektorrahmen (10) Metall aufweist oder wenigstens teilweise metallisiert ist,
**dadurch gekennzeichnet, dass**:
- das abstrahlende Element (20) durch die Stützstruktur (13; 16.3) innerhalb des inneren Abschnitts (16) so montiert ist, dass der innere Abschnitt (16) in eine Rückreflektorkavität (16.1) und einen offenen Abschnitt (16.2) aufgeteilt wird;
- der Reflektorrahmen (10), der das abstrahlende Element (20) in seinem Innern aufnimmt, oben auf der horizontalen metallischen Ebene (31) montiert ist, und
- ein Teilbereich (16.1) des inneren Abschnitts (16) zwischen dem Antennensubstrat (21) und der metallischen Ebene (31) ausgestaltet ist, um als Rückreflektorkavität (16.1) für die elektromagnetischen Wellen zu dienen, wobei die metallische Ebene (31) als ein Rückreflektor für das abstrahlende Element (20) agiert.

2. Antenneneinrichtung (100; 100A, 100B) nach Anspruch 1, wobei sie aufweist
- das gemeinsame Substrat (30) mit einer metallischen Ebene (31);
- die aktive Schaltung (40),
- elektrische Verbindungen (E1) zwischen der aktiven Schaltung (40) und dem Einspeisepunkt (24).

3. Antenneneinrichtung (100;100A; 100B) nach Anspruch 1 oder 2, wobei sie eine elektromagnetische Schnittstelle (EM2) und eine mechanische Schnittstelle (M2) zum Erstellen einer Verbindung zu einem Adapter (50) aufweist.

4. Antenneneinrichtung (100; 100A; 100B) nach Anspruch 3, wobei die mechanische Schnittstelle (M2) eine Plug-in-Verbindung zum Adapter (50) bereitstellt.

5. Antenneneinrichtung (100; 100A; 100B) nach Anspruch 3, **dadurch gekennzeichnet, dass** die wenigstens ein Passungselement (15) für einen mechanischen Eingriff oder eine mechanische Bindung mit dem Adapter (15) aufweist.

6. Antenneneinrichtung (100; 100A; 100B) nach einem der Ansprüche 1 bis 5, wobei sie Teil eines planen Schaltung zu Wellenleiter Übergangs ist.

7. Antenneneinrichtung (100; 100A; 100B) nach Anspruch 1 oder 2, wobei wenigstens jene Seitenwandungen (12) des Reflektorrahmens (10) metallisiert sind, die in Richtung auf den inneren Abschnitt (16) zeigen.

8. Antenneneinrichtung (100; 100A; 100B) nach Anspruch 2, wobei eine elektrisch leitfähige Verbindung zwischen der Seitenwandung (12) und der metallischen Ebene (31) vorgesehen ist.

9. Antenneneinrichtung (100; 100A; 100B) nach Anspruch 1 oder 2, wobei die obere horizontale Öffnung (11) als Apertur für die Emission von elektromagnetischen Wellen ausgebildet ist, die durch den Moduskonvertierungsbereich (23.1; 23.2) des abstrahlenden Elements (20) emittiert werden.

10. Antenneneinrichtung (100; 100A; 100B) nach Anspruch 2, wobei das Antennensubstrat (21) durch die Stützstruktur (13; 16.3) in einem Abstand (D) von der metallischen Ebene (31) aufgehängt ist.

11. Antenneneinrichtung (100; 100A; 100B) nach einem der vorhergehenden Ansprüche, wobei das Antennensubstrat (21) aus einem flexiblen dielektrischen Material hergestellt ist.

12. Antenneneinrichtung (100; 100A; 100B) nach einem der vorhergehenden Ansprüche 1 bis 9, wobei ein High-Definition Flüssigkristallpolymer-Flex-Substrat als Antennensubstrat (21) verwendet wird.

13. Antenneneinrichtung (100; 100A; 100B) nach einem der vorhergehenden Ansprüche, wobei die untere horizontale Öffnung (17) und das Antennensubstrat (21) Dimensionen haben, die es dem Antennensubstrat (21) gestatten, in den inneren Abschnitt (16) durch die untere horizontale Öffnung 817) eingesetzt zu werden.

14. Antenneneinrichtung (100; 100A; 100B) nach einem der vorhergehenden Ansprüche, wobei der Moduskonvertierungsbereich (23.1) eine rechteckförmige Form hat und aufweist:
- eine elektrisch leitfähige Platte (26) mit wenigstens einem Schlitz (71), wobei dieser Schlitz vorzugsweise in einem Zentrum des Moduskonvertierungsbereichs (23.1) platziert wird, wobei die Länge des Schlitzes (71) so gewählt wird, dass sie ungefähr gleich der Hälfte der Wellenlänge in der Mitte des beabsichtigten Frequenzbandes ist, und
wobei der Einspeisepunkt (24) aufweist:
- einen co-planaren Wellenleiter (27), der in den Moduskonvertierungsbereich (23.1) etwa in der Mitte einer seiner breiteren Kanten eintritt, wobei der co-planare Wellenleiter (27) durch zwei parallele Schlitze in einer dünnen elektrischen leitfähigen Platte (26) ausgebildet wird, was zu einem mittigen Leiter (28) und zwei Masse-oder Erdleitern führt.

15. Antenneneinrichtung (100; 100A; 100B) nach einem der vorhergehenden Ansprüche 1 bis 13, wobei der Moduskonvertierungsbereich (23.2) die Form einer modifizierten E-Probe bzw. E-Sonde einnimmt.

16. Kommunikationssystem (200) mit einer Antenneneinrichtung (100, 100A; 100B) nach einem oder mehreren der Ansprüche 1 bis 5, wenigstens einer aktiven Schaltung (40) und einem gemeinsamen Substrat (30), wobei die aktive Schaltung (40) und die Antenneneinrichtung (100; 100A; 100B) auf dem gemeinsamen Substrat (30) gelegen sind und die aktive Schaltung (40) über Speiseleitungen (25) des Einspeisepunkts (24) mit dem Moduskonvertierungsbereich (23.1; 23.2) verbunden ist.

17. Kommunikationssystem nach Anspruch 16, wobei der Einspeisepunkt (24) für einen flexiblen Übergang zwischen der aktiven Schaltung (40) und dem Moduskonvertierungsbereich (23.1; 23.2) vorgesehen ist.

## Revendications

1. Dispositif d'antenne montable en surface (100 ; 100A ; 100B) comprenant
- un châssis réflecteur (10) ayant
o des parois latérales circonférentielles (12) permettant de définir latéralement une section intérieure (16),
o une ouverture latérale (14) dans une de ces parois latérales (12),
o une ouverture supérieure horizontale (11) servant en tant qu'ouverture électromagnétique,
o une ouverture inférieure horizontale (17), et
o une structure support (13 ; 16.3) faisant partie intégrante du châssis réflecteur (10),
- un élément rayonnant (20) ayant
o un substrat à antenne plan et orienté horizontalement (21) avec une zone de conversion de mode (23.1 ;23.2) et avec un point d'alimentation en forme de levier (24) s'étendant depuis la zone de conversion de mode (23.1 ;23.2) dans une direction essentiellement horizontale,
dans lequel ce point d'alimentation (24) s'étend depuis la section intérieure (16) au travers de l'ouverture latérale (14) dans le but d'être capable de permettre une connexion à un circuit actif (40),
dans lequel ce dispositif d'antenne (100; 100A; 100B) est monté sur un substrat commun (30) avec un plan métallique (31),
et
dans lequel ce châssis réflecteur (10) comprend du métal ou est au moins partiellement métallisé,
**caractérisé en ce que :**
- l'élément rayonnant (20) est monté par le biais de la structure support (13 ; 16.3) à l'intérieur de la section intérieure (16) de façon que cette section intérieure (16) est divisée en une cavité arrière réflectrice (16.1) et en une portion ouverte (16.2) ;
- le châssis réflecteur (10) supportant l'élément rayonnant (20) à l'intérieur est monté au-dessus du plan horizontal métallique (31), et
- une portion (16.1) de la section intérieure (16) entre le substrat d'antenne (21) et le plan métallique (31) est configurée pour être utilisée en tant que cavité réflectrice arrière (16.1) pour les ondes électromagnétiques, le plan métallique (31) agissant comme un réflecteur arrière pour l'élément rayonnant (20).

2. Le dispositif d'antenne (100 ; 100A ; 100B) de la revendication 1, comprenant
- le substrat commun (30) avec un plan métallique (31),
- le circuit actif (40),
- des connexions électriques (E1) entre le circuit actif (40) et le point d'alimentation (24).

3. Le dispositif d'antenne (100 ; 100A ; 100B) de la revendication 1 ou 2, comprenant une interface électromagnétique (EM2) et une interface mécanique (M2) pour établir une connexion vers un adaptateur (50).

4. Le dispositif d'antenne (100; 100A; 100B) de la revendication 3, dans lequel l'interface mécanique (M2) permet une connexion enfichable à l'adaptateur (50).

5. Le dispositif d'antenne (100 ; 100A ; 100B) de la revendication 3, **caractérisé en ce qu'**il comprend au moins un élément d'accouplement (15) pour une liaison mécanique avec l'adaptateur (50).

6. Le dispositif d'antenne (100 ; 100A ; 100B) de l'une quelconque des revendications 1 à 5, faisant partie d'une transition plan de circuit à guide d'onde.

7. Le dispositif d'antenne (100 ; 100A ; 100B) de la revendication 1 ou 2, dans lequel au moins celles des parois (12) du châssis réflecteur (10) qui font face à la section intérieure (16) sont métallisées.

8. Le dispositif d'antenne (100; 100A ; 100B) de la revendication 2, dans lequel une connexion conductrice électriquement est prévue entre la paroi (12) et le plan métallique (31).

9. Le dispositif d'antenne (100 ; 100A ; 100B) de la revendication 1 ou 2, dans lequel l'ouverture supérieure horizontale (11) est conçue comme une ouverture pour l'émission d'ondes électromagnétiques émises par la zone de conversion de mode (23.1; 23.2) de l'élément rayonnant (20).

10. Le dispositif d'antenne (100 ; 100A ; 100B) de la revendication 2, dans lequel le substrat d'antenne (21) est suspendu par la structure support (13 ; 16.3) à une distance (D) du plan métallique (31).

11. Le dispositif d'antenne (100; 100A; 100B) de l'une des revendications précédentes, dans lequel le substrat d'antenne (21) est réalisé à partir d'un matériau souple, diélectrique.

12. Le dispositif d'antenne (100 ; 100A ; 100B) de l'une des revendications précédentes 1 à 9, dans lequel un substrat flexible en polymère à cristaux liquides à haute définition est utilisé en tant que substrat d'antenne (21).

13. Le dispositif d'antenne (100 ; 100A ; 100B) de l'une des revendications précédentes, dans lequel l'ouverture basse horizontale (17) et le substrat d'antenne (21) ont des dimensions qui autorisent le substrat d'antenne (21) à être inséré dans la section intérieure (16) au travers de l'ouverture basse horizontale (17).

14. Le dispositif d'antenne (100 ; 100A ; 100B) de l'une des revendications précédentes, dans lequel la zone de conversion de mode (23.1) a une forme rectangulaire et comprend :
- une feuille électriquement conductrice (26) ayant au moins une fente (71), cette fente (71) étant de préférence placée dans un centre de la zone de conversion de mode (23.1), la longueur de la fente (71) étant choisie pour être égale à approximativement la moitié de la longueur d'onde au centre de la bande de fréquences attendue, et
dans lequel le point d'alimentation (24) comprend :
- un guide d'onde coplanaire (27) qui pénètre la zone de conversion de mode (23.1) approximativement au centre de l'un de ses côtés les plus larges, le guide d'onde coplanaire (27) étant formé par deux fentes parallèles dans une fine feuille électriquement conductrice (26), résultant en un conducteur central (28) et deux conducteurs de masse (29).

15. Le dispositif d'antenne (100 ; 100A ; 100B) de l'une des revendications précédentes 1 à 13, dans lequel la zone de conversion de mode (23.2) prend la forme d'une sonde de champ électrique modifiée.

16. Système de communication (200) comprenant un dispositif d'antenne (100; 100A ; 100B) conformément à l'une ou plusieurs des revendications 1 à 5, au moins un circuit actif (40) et un substrat commun (30), le circuit actif (40) et le dispositif d'antenne (100 ; 100A ; 100B) étant situés sur le substrat commun (30) et le circuit actif (40) étant connecté via des lignes d'alimentation (25) du point d'alimentation (24) à la zone de conversion de mode (23.1 ;23.2).

17. Le système de communication de la revendication 16, dans lequel le point d'alimentation (24) permet une transition flexible entre le circuit actif (40) et la zone de conversion de mode (23.1; 23.2).
